# EUROPEAN PATENT APPLICATION

(11) **EP 4 539 097 A1**
(43) Date of publication of application: **16.04.2025**
(21) Application number: 23819790.9
(22) Date of filing: 05.06.2023
(51) Int. Cl.: H01L 21/02, B23K 20/00

(54) **BONDING METHOD**

(30) Priority: 08.06.2022 JP 2022092780
(71) Applicant: Tazmo Co., Ltd., Okayama-shi, Okayama 701-1221 (JP)
(72) Inventor: IKAGAWA, Yoshinori, Okayama-shi, Okayama 701-1221 (JP)
(74) Representative: Knöner, Gregor
(86) International application number: PCT/JP2023/020744
(87) International publication number: WO 2023/238810

(57) **Abstract**

A joining method comprises a stacking step and a joining process step. **In** the stacking step, a first joining target and a second joining target are stacked in such a manner as to interpose a heat absorbing layer and a joining material layer between respective j oint surfaces of the first joining target and the second joining target. **In** the joining process step, laser light is applied to the heat absorbing layer to heat the joining material layer with heat absorbed by the heat absorbing layer from the laser light, thereby joining the first joining target and the second joining target to each other using the joining material layer.

## Description

### Technical Field

The present invention relates to a joining technique using laser light.

### Background Art

One of existing techniques of manufacturing semiconductor devices (such as MEMSs) is a technique of joining two wafers to each other utilizing eutectic reaction between two types of metals. According to this technique, a metal layer containing one of two types of metals to generate eutectic reaction as a major constituent and a metal layer containing the other metal as a major constituent are formed on respective joint surfaces of two wafers. As a combination of the two types of metals to generate eutectic reaction, a combination of aluminum (Al) and germanium (Ge) is used, for example. Eutectic reaction is generated at a place of contact between the metal layers, thereby joining the two wafers to each other.

Such a joining technique is used for sealing a sensor (such as a gyroscope sensor or a biosensor) or a waveguide in a device, for example. To generate the above-described eutectic reaction, it is required to heat the place of contact between the two metal layers to a temperature at which the eutectic reaction is generated. What has conventionally been done for achieving this is to bring the two metal layers into contact with each other by interposing the two wafers under pressure and in this state, to heat the two wafers entirely together with a sensor, etc. to be sealed (see Patent Literature 1, for example).

### Citation List

### Patent Literatures

Patent literature 1: Japanese published unexamined patent application No. 11-220141 (1999)
Patent Literature 2: Chinese published utility model registration No. 210223961

### Summary of Invention

### Technical Problem

According to the above-described conventional joining technique, however, heating even a sensor to be sealed causes a risk of damage of the sensor with heat. Hence, a sensor that can be sealed in a device is limited to a sensor having high heat resistance. Furthermore, temperature increase at a joining place (temperature increase to a temperature at which eutectic reaction is generated) takes long time. Additionally, as it is required to relieve thermal stress on the wafers gradually after the joining, temperature decrease also takes long time. Hence, a problem arises in that long time is required for performing a joining process once.

Another problem also arises in that, if the above-described two types of metals have different values of coefficients of linear expansion, a place of joining between the two metal layers is exposed to a risk of distortion during temperature increase (during heating) or during temperature decrease (during cooling). Hence, in selecting the two types of metals according to the above-described conventional joining technique, it is required to select metals having approximate values of coefficients of linear expansion in order to reduce the occurrence of such distortion. This imposes severe limitation on a degree of freedom in the selection.

In response to this, according to a technique recently suggested, heat is applied locally to a place of contact between two metal layers as a target using laser light (see Patent Literature 2). More specifically, two wafers are interposed under pressure between a quartz plate transmissive to laser light and a different member (such as a chuck), and in this state, laser light is applied through the quartz plate to the place of contact between the two metal layers.

According to this joining technique using laser light, as the place of contact between the two metal layers is heated locally, thermal influence on a sensor is reduced. As a result, it becomes possible to seal a sensor with low heat resistance in a device. Furthermore, as a place of joining between the two metal layers can be heated intensively with laser light, a temperature at the joining place can be increased rapidly to a temperature at which eutectic reaction is generated. As a result, it becomes possible to shorten time required for a joining process.

If the above-described two types of metals have different values of coefficients of linear expansion and if distortion occurs during temperature increase (during heating) or during temperature decrease (during cooling), the occurrence of the distortion is limited only to a local area to be applied with laser light. Thus, the amount of distortion is considerably small, so that influence of the distortion on the place of joining between the two metal layers is considerably small. Thus, in selecting the two types of metals, it becomes possible to select metals having different values of coefficients of linear expansion to increase a degree of freedom in the selection.

On the other hand, in many cases, metals to generate eutectic reaction are relatively high in light reflectance and light transmittance, so that such metals have difficulty in absorbing laser light efficiently. Germanium (Ge) as one of such metals has relatively high absorbency of laser light. Nevertheless, germanium can absorb only about 35% of applied laser light for reason of having a reflectance of about 35% and a transmittance of about 30%. Hence, a technique of generating eutectic reaction using laser light encounters a problem in that it is difficult to heat a metal layer as a target efficiently and a problem in that reflected or transmitted light might adversely affect a sensor and others.

The present invention is intended to allow laser light to be used efficiently in a joining technique using the laser light.

### Solution to Problem

A first joining method according to the present invention comprises a stacking step and a joining process step. In the stacking step, a first joining target and a second joining target are stacked in such a manner as to interpose a heat absorbing layer and a joining material layer between respective joint surfaces of the first joining target and the second joining target. In the joining process step, laser light is applied to the heat absorbing layer to heat the joining material layer with heat absorbed by the heat absorbing layer from the laser light, thereby joining the first joining target and the second joining target to each other using the joining material layer.

According to the first joining method, even if the joining material layer contains a material having low absorbency of laser light as a major constituent and thus it is difficult to heat the joining material layer efficiently by application of laser light to the joining material layer, applying laser light to the heat absorbing layer causes the heat absorbing layer to absorb the laser light efficiently, thereby allowing the joining material layer to be heated indirectly through the heat absorbing layer.

A second joining method according to the present invention is a method of joining a first joining target and a second joining target to each other using laser light, and comprises a joining material layer forming step, a stacking step, and a joining process step. In the joining material layer forming step, a joining material layer containing at least one type out of titanium (Ti), chromium (Cr), and oxides thereof as a major constituent is formed along at least one of a j oint surface of the first joining target and a joint surface of the second joining target. In the stacking step, the first joining target and the second joining target are stacked in such a manner as to interpose the joining material layer between the respective joint surfaces of the first joining target and the second joining target. In the joining process step, laser light is applied to the joining material layer to heat the joining material layer, thereby joining the first joining target and the second joining target to each other using the joining material layer.

According to the second joining method, applying laser light to the joining material layer causes the joining material layer to absorb the laser light efficiently, thereby allowing the respective joint surfaces of the two joining targets to be joined to each other.

### Advantageous Effects of Invention

According to the present invention, it is possible to use laser light efficiently in a joining technique using the laser light.

### Brief Description of Drawings

FIG. 1 is a conceptual view showing an example of a joining apparatus available for a joining method according to the present invention.
FIG. 2 is a conceptual view illustrating a joining target in a first embodiment.
FIG. 3A is a sectional view showing examples of pattern shapes of metal layers, and Fig. 3B is a plan view showing these examples.
FIG. 4 is a flowchart showing a joining method according to the first embodiment.
FIG. 5 is a conceptual view illustrating a joining target in a second embodiment.

### Description of Embodiments

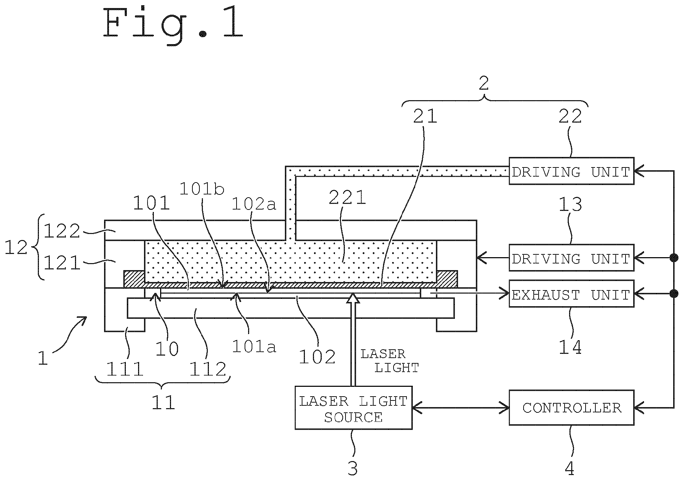

[1] Joining Target FIG. 1 is a conceptual view showing a joining apparatus available for a joining method according to the present invention. As shown in FIG. 1, the joining apparatus joins two joining targets 101 and 102 to each other, and includes a chamber mechanism 1, a pressurizing mechanism 2, a laser light source 3, and a controller 4. The configuration of each part will be described below in detail.

### <Chamber Mechanism 1>

The chamber mechanism 1 includes a first chamber structure unit 11, a second chamber structure unit 12, a driving unit 13, and an exhaust unit 14.

The first chamber structure unit 11 and the second chamber structure unit 12 form enclosed space (hereinafter called a "chamber 10") for implementation of a joining process. The first chamber structure unit 11 and the second chamber structure unit 12 are configured to realize formation and opening of the chamber 10 selectively by moving closer to and away from each other in a vertical direction. Particulars thereof will be described below.

The first chamber structure unit 11 is composed of a first circular cylindrical part 111, and a stage 112 supported inside the first circular cylindrical part 111 with no gap therebetween. The first circular cylindrical part 111 is arranged with a center axis thereof extending in a direction conforming to the vertical direction. The stage 112 is supported horizontally by the first circular cylindrical part 111. Here, the stage 112 is transmissive to laser light and is made of quartz, for example. The two joining targets 101 and 102 are mounted on the stage 112 with respective joint surfaces 101a and 102a facing each other. In a case illustrated in FIG. 1, the joining targets 101 and 102 are mounted on the stage 112 with the joining target 101 located in a higher position.

The second chamber structure unit 12 is composed of a second circular cylindrical part 121 arranged over the first circular cylindrical part 111 and coaxially with the first circular cylindrical part 111, and a top plate 122 closing an upper end of the second circular cylindrical part 121. An upper end of the first circular cylindrical part 111 and a lower end of the second circular cylindrical part 121 contact each other with no gap therebetween, thereby forming the chamber 10 between the stage 112 and the top plate 122.

The driving unit 13 moves at least one of the first chamber structure unit 11 and the second chamber structure unit 12 in the vertical direction, thereby causing these structure units to move closer to and farther from each other relatively.

The exhaust unit 14 reduces an internal pressure in the chamber 10 (more specifically, space as part of the chamber 10 and defined between a diaphragm 21 described later and the stage 112) until a vacuum state is formed in the chamber 10. For example, an air pressure adjuster such as a vacuum pump is used as the exhaust unit 14. The chamber mechanism 1 may further include a gas supplier that supplies processing gas (such as argon (Ar) gas) into the chamber 10.

### <Pressurizing Mechanism 2>

The pressurizing mechanism 2 applies a pressure to the joining targets 101 and 102 from an opposite side to the stage 112. In the present embodiment, the pressurizing mechanism 2 is composed of the diaphragm 21, and a driving unit 22 that actuates the diaphragm 21. Of the two joining targets 101 and 102, the pressurizing mechanism 2 applies a pressure to a back surface 101b of the joining target 101 opposite to the stage 112. Particulars thereof will be described below.

The diaphragm 21 is supported inside the second circular cylindrical part 121 with no gap therebetween in a manner allowing the diaphragm 21 to come into contact with the back surface 101b of the joining target 101 when the chamber 10 is formed.

The driving unit 22 transmits a pressure to the diaphragm 21 using a transmission medium 221, thereby actuating the diaphragm 21. More specifically, the transmission medium 221 is packed in between the diaphragm 21 and the top plate 122 inside the second chamber structure unit 12. The driving unit 22 changes a pressure to be applied to the transmission medium 221, thereby actuating the diaphragm 21 through the transmission medium 221. Here, the transmission medium 221 may be liquid or gas.

### <Laser Light Source 3>

The laser light source 3 emits laser light, and is arranged below the stage 112 transmissive to laser light. The laser light source 3 is capable of performing a scan with laser light within a horizontal plane along a pattern shape of an intervening layer such as a metal layer 201 described later while applying the laser light through the stage 112 toward the joining targets 101 and 102 on the stage 112. The laser light source 3 is further capable of focusing the laser light on a place of joining between the joining target 101 and the joining target 102.

### <Controller 4>

The controller 4 is composed of a processor such as a CPU (central processing unit) or a microcomputer, and controls various operation units (including the chamber mechanism 1, the pressurizing mechanism 2, and the laser light source 4) of the joining apparatus. Particulars thereof will be described below.

During implementation of the joining process, while the two joining targets 101 and 102 are mounted on the stage 112, the controller 4 causes the first chamber structure unit 11 and the second chamber structure unit 12 to move closer to each other to unite these structure units, thereby forming the chamber 10. Then, the controller 4 controls the exhaust unit 14 to reduce an internal pressure in the chamber 10 (more specifically, space as part of the chamber 10 and defined between the diaphragm 21 and the stage 112) until a vacuum state is formed in the chamber 10. The controller 4 supplies processing gas (such as argon (Ar) gas) into the chamber 10, as necessary.

Next, the controller 4 controls the pressurizing mechanism 2 to apply a pressure to the back surface 101b of the joining target 101 using the diaphragm 21.

The diaphragm 21 is flexibly changeable in conformity with the shape of the back surface 101b of the joining target 101 when a pressure is applied to the back surface 101b. This allows the diaphragm 21 to tightly contact the back surface 101b of the joining target 101 and apply the pressure to the back surface 101b uniformly, making it possible to cause deformation (including elastic deformation) of the joining target 101 with the applied pressure. The diaphragm 21 follows change in the shape of the back surface 101b of the joining target 101 resulting from the deformation of the joining target 101, so that the uniform pressure can be applied continuously to the back surface 101b. Thus, by the uniform pressure to the back surface 101b of the joining target 101 using the diaphragm 21, even if the applied pressure is relatively low, it is still possible to deform the joining target 101 in such a manner as to interpose the intervening layer (such as the metal layer 201) between the two joining targets 101 and 102 with no gap from the joining targets 101 and 102, and to maintain the resultant state. By reducing a pressure required for the joining in this way, strength required for the stage 112 is also reduced correspondingly (strength providing resistance to pressure application during joining). As a result, it becomes possible to reduce the stage 112 in a relatively small thickness.

In a state after the pressure is applied by the pressurizing mechanism 2 to the back surface 101b of the joining target 101, the controller 4 controls the laser light source 3 while maintaining this state, thereby applying laser light through the stage 112 to a place of joining between the joining target 101 and the joining target 102. The controller 4 performs a scan with the laser light within a horizontal plane along the pattern shape of the intervening layer (such as the metal layer 201). By doing so, the respective joint surfaces 101a and 102a of the two joining targets 101 and 102 are joined to each other over the entire areas of the joining targets 101 and 102.

In the above-described joining apparatus, the diaphragm 21 may have a suction surface to which the back surface 101b of the joining target 101 is to be sucked (specifically, may have the function of chucking the joining target 101). The joining apparatus may further include an alignment mechanism that adjusts the positions of the joining target 101 held on (sucked to) the diaphragm 21 and the joining target 102 mounted on the stage 112 relative to each other. As an example, the alignment mechanism can be used for adjusting the positions of the joining target 101 held on (sucked to) the diaphragm 21 and the joining target 102 mounted on the stage 112 relative to each other by adjusting the position of at least one of the first chamber structure unit 11 and the second chamber structure unit 12 in a horizontal plane.

In the above-described joining apparatus, the pressurizing mechanism 2 is not limited to the mechanism composed of the diaphragm 21 but can be changed to a different mechanism capable of applying a pressure to the back surface 101b of the joining target 101, as appropriate. Furthermore, the positions of the stage 112 and the pressurizing mechanism 2 (diaphragm 21) relative to each other may also be changed to relative positions switched from each other vertically, as appropriate. In response to this, the positions of the other units (including the laser light source 3) may be changed, as appropriate.

In the above-described joining apparatus, when the joining target 102 is mounted on the stage 112, the joining target 102 comes into surface contact with a mounting surface of the stage 112 (a surface for mounting of the joining target 102). If the joining target 102 is made of a material as a major constituent having a different refractive index from a material forming the stage 112 (as an example, if the stage 112 is a quartz plate and the joining target 102 is a silicon (Si) wafer), laser light is reflected easily at an interface between the stage 112 and the joining target 102. To prevent such reflection of the laser light, an anti-reflection film may be formed on the mounting surface of the stage 112.

Likewise, laser light is also reflected on a back surface of the stage 112 (a surface opposite to the mounting surface and a surface to touch air outside the chamber 10) as a result of a difference in refractive index between the stage 112 and air. To prevent such reflection of the laser light, an anti-reflection film may be formed on the back surface of the stage 112.

### [2] Joining Target and Joining Method

### [2-1] First Embodiment

### [2-1-1] Joining Target

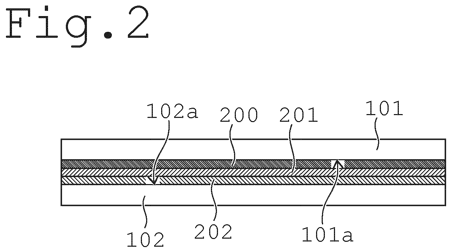

FIG. 2 is a conceptual view showing examples of two joining targets 101 and 102 that can be joined to each other by the above-described joining apparatus. The joining targets 101 and 102 are semiconductor wafers or glass plates, for example, and have respective joint surfaces 101a and 102a on which a heat absorbing layer 200 and metal layers 201 and 202 for joining between the joint surfaces 101a and 102a (joining material layers) are formed as follows.

The heat absorbing layer 200 is formed on and along the joint surface 101a of the joining target 101 (heat absorbing layer forming step). The metal layer 201 is further formed on and along a surface of the heat absorbing layer 200 (joining material layer forming step). The metal layer 202 is formed on and along the joint surface 102a of the joining target 102 (joining material layer forming step). In terms of a relationship between a "first joining target" and a "second joining target" described in claims, the joining target 101 corresponds to the "first joining target" and the joining target 102 corresponds to the "second joining target."

The metal layer 201 is a joining material layer containing one of two types of metals to generate eutectic reaction as a major constituent, and the metal layer 202 is a joining material layer containing the other metal as a major constituent. Examples of a combination of the two types of metals include a combination of aluminum (Al) and germanium (Ge), a combination of copper (Cu) and tin (Sn), a combination of silver (Ag) and tin (Sn), and a combination of indium (In) and tin (Sn).

Meanwhile, many of these metals to generate eutectic reaction have difficulty in absorbing laser light efficiently. For example, metals such as aluminum (Al), silver (Ag), and gold (Au) have difficulty in absorbing laser light efficiently for reason of having high reflectances. Additionally, germanium (Ge) is a metal through which light is transmitted partially (having a transmittance of about 30%). Thus, if germanium (Ge) is used as a major constituent of one of the metal layers 201 and 202 and this metal layer has a thickness on the same order as the wavelength of light, an interference phenomenon of light is caused in the metal layer and this becomes a hindrance to absorption of laser light. Hence, dispersion in the thickness of the metal layer (thickness dispersion around plus or minus 10%) make efficiency in laser light absorption non-uniform in this metal layer, leading to non-uniformity of a joined state. For these reasons, the technique of generating eutectic reaction using laser light encounters a problem in that it is difficult to heat the metal layers 201 and 202 as targets efficiently and a problem in that reflected or transmitted light might adversely affect a sensor 103 and others.

In response to this, the heat absorbing layer 200 is formed in order to allow laser light to be used efficiently. More specifically, the heat absorbing layer 200 contains a material as a major constituent having higher absorbency of laser light than the metals forming the metal layers 201 and 202. More specifically, the heat absorbing layer 200 contains at least one type out of titanium (Ti), chromium (Cr), and oxides thereof as a major constituent. While titanium (Ti), chromium (Cr), and oxides thereof are higher in reflectance than germanium (Ge), these materials are materials through which transmission of light to become a cause for the above-described interference phenomenon is very little so they can absorb about 40% of applied laser light stably as heat. The material forming the heat absorbing layer 200 is not limited to titanium (Ti), chromium (Cr), and oxides thereof but a material having higher absorbency of laser light than the metals forming the metal layers 201 and 202 is available, if appropriate. As an example, such a material may be prepared by dispersing a heat absorbing material such as carbon in resin.

With the presence of the heat absorbing layer 200, even if the metal layers 201 and 202 contain metals having low absorbency of laser light as major constituents and thus it is difficult to heat the metal layers 201 and 202 efficiently by application of laser light to the metal layers 201 and 202, applying laser light to the heat absorbing layer 200 causes the heat absorbing layer 200 to absorb the laser light efficiently, thereby allowing the metal layers 201 and 202 to be heated indirectly through the heat absorbing layer 200.

While not particularly limited, each of the above-described layers is formed by vacuum film deposition (including sputtering and vapor deposition) of a corresponding material or application of the material on the joint surfaces 101a and 102a.

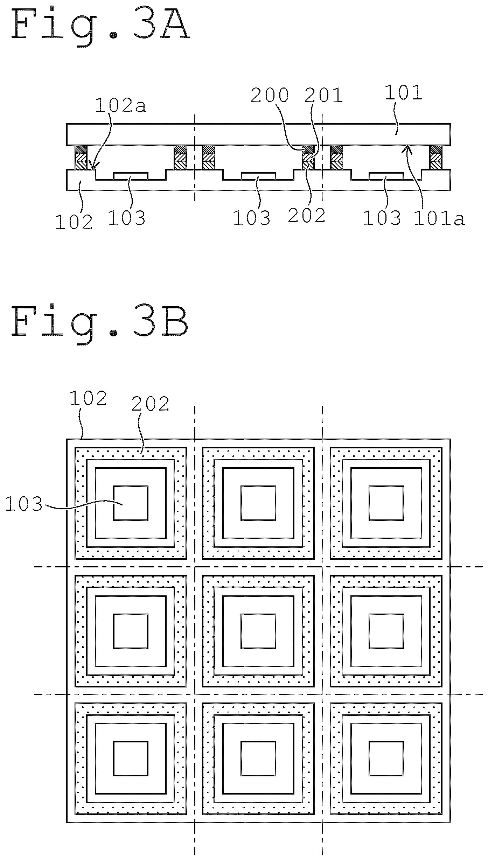

FIG. 2 schematically shows a case where the metal layer 201 is formed over the entire area of the joint surface 101a and the metal layer 202 is formed over the entire area of the joint surface 102a. In an actual process of manufacturing a semiconductor device (such as a MEMS), however, the metal layers 201 and 202 are patterned into various shapes in conformity with the shape or purpose of use of the device, for example. At this time, the heat absorbing layer 200 may also be patterned into the same shape as the metal layer 201. FIGS. 3A and 3B are a sectional view and a plan view respectively showing examples of pattern shapes of the metal layers 201 and 202. Of the metal layers 201 and 202, FIG. 3B shows only the metal layer 202 in a plan view. In this example, in order to allow one sensor 103 to be sealed in each device, the metal layers 201 and 202 are each formed into a quadrangular frame-like shape surrounding one sensor 103. The heat absorbing layer 200 is also formed into the same shape as the metal layer 201. The pattern shape of each of the metal layer 201 and the metal layer 202 is not limited to a quadrangular frame-like shape but is appropriately changeable in conformity with the shape or purpose of use of a device, for example.

### [2-1-2] Joining Method

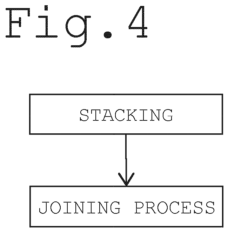

Described next is a joining method of joining the joining targets 101 and 102 to each other (see FIG. 2) using laser light. FIG. 4 is a flowchart showing a joining method according to the first embodiment. The joining method of the present embodiment includes a stacking step and a joining process step performed using the above-described joining apparatus. The stacking step and the joining process step will be described below in detail. The joining method of the present embodiment may further include at least one of a heat absorbing layer forming step of forming the heat absorbing layer 200 and a metal layer forming step of forming the metal layers 201 and 202.

In the stacking step, the joining targets 101 and 102 are stacked on each other in such a manner as to generate a state where the heat absorbing layer 200, the metal layer 201, and the metal layer 202 are interposed between the respective joint surfaces 101a and 102a of the joining targets 101 and 102. More specifically, the joining targets 101 and 102 are mounted on the stage 112 of the joining apparatus in such a manner as to generate this state (see FIG. 1).

In the joining process step, laser light is applied to the heat absorbing layer 200 to heat the metal layers 201 and 202 with heat absorbed by the heat absorbing layer 200 from the laser light. By doing so, the metal layers 201 and 202 are connected to each other utilizing eutectic reaction between the two types of metals generated by the heating, thereby joining the respective joint surfaces 101a and 102a of the two joining targets 101 and 102 to each other.

More specifically, while the two joining targets 101 and 102 are mounted on the stage 112, the controller 4 of the joining apparatus causes the first chamber structure unit 11 and the second chamber structure unit 12 to move closer to each other to unite these structure units, thereby forming the chamber 10. Then, the controller 4 controls the exhaust unit 14 to reduce an internal pressure in the chamber 10 until a vacuum state is formed in the chamber 10. Next, the controller 4 controls the pressurizing mechanism 2 to apply a pressure to the back surface 101b of the joining target 101 using the diaphragm 21. While maintaining applying the pressure, the controller 4 controls the laser light source 3 to apply laser light through the stage 112 to the heat absorbing layer 200. The controller 4 performs a scan with the laser light within a horizontal plane along the pattern shape of the intervening layer (such as the metal layer 201). By doing so, the metal layers 201 and 202 are heated through the heat absorbing layer 200 over the entire areas of the joining targets 101 and 102. Then, utilizing eutectic reaction generated therefrom, the metal layers 201 and 202 are connected to each other, thereby joining the respective joint surfaces 101a and 102a of the two joining targets 101 and 102 to each other.

This joining method causes the heat absorbing layer 200 to absorb laser light efficiently, thereby allowing the metal layers 201 and 202 to be heated indirectly through the heat absorbing layer 200, as described above. As a result, joining efficiently using laser light is realized.

### [2-1-3] Modifications

### <First Modification>

The above-described joining method is applicable not only to joining utilizing eutectic reaction (eutectic bonding) but is also effective in joining the two joining targets 101 and 102 to each other using at least one joining material layer, which includes joining using a material having a high reflectance or a material having a high light transmittance, solder joining, or weld joining, as such joining also allows the joining material layer to be heated using the heat absorbing layer 200. In this case, in the joining material layer forming step, it is possible to form the joining material layer along at least one of a surface of the heat absorbing layer 200 and the joint surface 102a of the joining target 102.

### <Second Modification>

In the above-described joining method, if the efficiency of heat absorption by the heat absorbing layer 200 is desired to be increased further, treatment such as chemical treatment or blast treatment for increasing surface roughness may be performed on a surface of the heat absorbing layer 200 before the stacking step (surface treatment step).

### <Third Modification>

In the above-described joining method, if at least one of the joining targets 101 and 102 contains a material having a high heat conductivity as a major constituent, heat generated by absorption of laser light by the heat absorbing layer 200 may be diffused into the joining target, causing a risk that efficient heating of the metal layers 201 and 202 might be hindered.

In order to prevent such heat diffusion, the joining target of the joining targets 101 and 102 containing the material having a high heat conductivity as a major constituent may be provided with a heat diffusion preventive layer on the joint surface thereof (preventive layer forming step). In this case, in the heat absorbing layer forming step or the metal layer forming step, the heat absorbing layer 200 or the metal layer 202, for example, is formed on a surface of the heat diffusion preventive layer.

### <Fourth Modification>

The above-described joining method is applicable not only to complete joining of joining a place of contact entirely between the metal layers 201 and 202 with laser light but also to provisional joining of joining only some parts of the place of contact between the metal layers 201 and 202 with laser light. Here, the provisional joining is a joining process performed to maintain the positions of the joining targets 101 and 102 relative to each other adjusted by the alignment mechanism (not shown in the drawings) so as not to cause disturbance of the relative positions due to vibration occurring during transport, for example.

The joining apparatus used in the above-described joining method is not limited to the joining apparatus illustrated in FIG. 1 but a different joining apparatus is also applicable, as long as the joining apparatus allows application of laser light to a place of joining between the joining targets 101 and 102 while interposing the joining targets 101 and 102 under pressure.

### [2] Second Embodiment

### [2-2-1] Joining Target

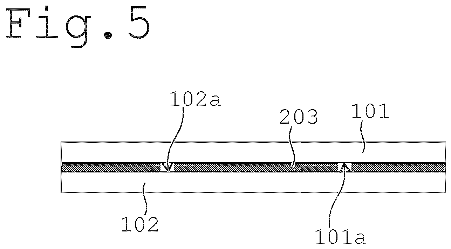

FIG. 5 is a conceptual view showing different examples of two joining targets 101 and 102 that can be joined to each other by the above-described joining apparatus. The joining targets 101 and 102 are semiconductor wafers or glass plates, for example, and a joining material layer 203 is formed along one of respective joint surfaces 101a and 102a of the joining targets 101 and 102 (joining material layer forming step). Here, the joining material layer 203 contains at least one type out of titanium (Ti), chromium (Cr), and oxides thereof as a major constituent. In terms of the relationship between the "first joining target" and the "second joining target" described in claims, it may be considered that the joining target 101 corresponds to the "first joining target" and the joining target 102 corresponds to the "second joining target." Conversely, it may be considered that the joining target 102 corresponds to the "first joining target" and the joining target 101 corresponds to the "second joining target." The joining material layer 203 may be formed on each of the joint surfaces 101a and 102a.

As described in the first embodiment, titanium (Ti), chromium (Cr), and oxides thereof are metals having high absorbency of laser light. The present inventor has found that, even in the absence of the metal layers 201 and 202 to be connected to each other by eutectic reaction unlike in the first embodiment, forming the joining material layer 203 using titanium (Ti), chromium (Cr), or an oxide of either of them having such properties makes it possible to join the respective joint surfaces 101a and 102a of the two joining targets 101 and 102 to each other only by the provision of the joining material layer 203.

Thus, with the provision of the joining material layer 203, applying laser light to the joining material layer 203 causes the joining material layer 203 to absorb the laser light efficiently, thereby allowing the respective joint surfaces 101a and 102a of the two joining targets 101 and 102 to be joined to each other.

### [2-2-2] Joining Method

Described next is a joining method of joining the joining targets 101 and 102 to each other (see FIG. 5) using laser light. Like in the flowchart shown in FIG. 4, the joining method of the present embodiment includes a stacking step and a joining process step performed using the above-described joining apparatus. The stacking step and the joining process step will be described below in detail. The joining method of the present embodiment may further include a joining material layer forming step of forming the joining material layer 203.

In the stacking step, the joining targets 101 and 102 are stacked on each other in such a manner as to generate a state where the joining material layer 203 is interposed between the respective joint surfaces 101a and 102a of the joining targets 101 and 102. More specifically, the joining targets 101 and 102 are mounted on the stage 112 of the joining apparatus in such a manner as to generate this state (see FIG. 1).

In the joining process step, laser light is applied to the joining material layer 203 to cause the joining material layer 203 to absorb the laser light, thereby heating the joining material layer 203. By heating the joining material layer 203 in this way, the respective joint surfaces 101a and 102a of the two joining targets 101 and 102 are joined to each other.

More specifically, while the two joining targets 101 and 102 are mounted on the stage 112, the controller 4 of the joining apparatus causes the first chamber structure unit 11 and the second chamber structure unit 12 to move closer to each other to unite these structure units, thereby forming the chamber 10. Then, the controller 4 controls the exhaust unit 14 to reduce an internal pressure in the chamber 10 until a vacuum state is formed in the chamber 10. Next, the controller 4 controls the pressurizing mechanism 2 to apply a pressure to the back surface 101b of the joining target 101 using the diaphragm 21. While maintaining applying the pressure, the controller 4 controls the laser light source 3 to apply laser light through the stage 112 to the joining material layer 203. The controller 4 performs a scan with the laser light within a horizontal plane along a pattern shape of the joining material layer 203. By doing so, the joining material layer 203 is heated over the entire areas of the joining targets 101 and 102. As a result of heating the joining material layer 203, the respective joint surfaces 101a and 102a of the two joining targets 101 and 102 are joined to each other.

This joining method causes the joining material layer 203 to absorb laser light efficiently, thereby allowing the two joining targets 101 and 102 to be joined to each other. As a result, joining efficiently using laser light is realized.

### [2-2-3] Modifications

### <Fifth Modification>

Like in the first embodiment, in the above-described joining technique, a heat diffusion preventive layer may also be formed on the joint surface of the joining target in order to prevent heat diffusion into this joining target (preventive layer forming step).

### <Sixth Modification>

Like in the first embodiment, the above-described joining technique is applicable not only to the complete joining but also to the provisional joining. Furthermore, the joining apparatus used in the above-described joining method is not limited to the joining apparatus illustrated in FIG. 1 but a different joining apparatus is also applicable, as long as the joining apparatus allows application of laser light to a place of joining between the joining targets 101 and 102 while interposing the joining targets 101 and 102 under pressure.

The above explanations of the embodiments and the modifications are nothing more than illustrative in any respect, nor should be thought of as restrictive. The scope of the present invention is indicated by claims rather than the above embodiments and modifications. Furthermore, it is intended that all changes that are equivalent to a claim in the sense and realm of the doctrine of equivalence be included within the scope of the present invention.

A subject to be extracted as an invention from the above-described embodiments and modifications includes not only the above-described joining methods but may also include some of the steps forming the joining methods (the stacking step and the joining process step, for example), a joining apparatus used for implementing the joining methods, and others.

### Reference Signs List

1 Chamber mechanism
2 Pressurizing mechanism
3 Laser light source
4 Controller
10 Chamber
11 First chamber structure unit
12 Second chamber structure unit
13 Driving unit
14 Exhaust unit
21 Diaphragm
22 Driving unit
101, 102 Joining target
101a, 102a Joint surface
101b Back surface
103 Sensor
111 First circular cylindrical part
112 Stage
121 Second circular cylindrical part
122 Top plate
200 Heat absorbing layer
201, 202 Metal layer (joining material layer)
203 Joining material layer
221 Transmission medium

## Claims

1. A joining method comprising:
a stacking step of stacking a first joining target and a second joining target in such a manner as to interpose a heat absorbing layer and a joining material layer between respective j oint surfaces of the first joining target and the second joining target; and
a joining process step of applying laser light to the heat absorbing layer to heat the joining material layer with heat absorbed by the heat absorbing layer from the laser light, thereby joining the first joining target and the second joining target to each other using the joining material layer.

2. The joining method according to claim 1, wherein
the heat absorbing layer contains at least one type out of titanium (Ti), chromium (Cr), and oxides thereof as a major constituent.

3. The joining method according to claim 1 or 2, further comprising:
a surface treatment step of increasing surface roughness at the heat absorbing layer before the stacking step.

4. A joining method comprising:
a stacking step of stacking a first joining target and a second joining target in such a manner as to interpose a joining material layer between respective joint surfaces of the first joining target and the second joining target, the joining material layer containing at least one type out of titanium (Ti), chromium (Cr), and oxides thereof as a major constituent; and
a joining process step of applying laser light to the joining material layer to heat the joining material layer, thereby joining the first joining target and the second joining target to each other using the joining material layer.

5. The joining method according to any one of claims 1 to 4, wherein
a heat diffusion preventive layer is formed on at least one of the respective joint surfaces of the first joining target and the second joining target.
